**Europäisches Patentamt**

**European Patent Office**

**Office européen des brevets**

(19)

(11) Publication number : **0 614 533 B1**

## (12) EUROPEAN PATENT SPECIFICATION

(45) Date of publication of patent specification :
02.11.95 Bulletin 95/44

(51) Int. Cl.⁶ : **G01R 35/00**

(21) Application number : **92924358.2**

(22) Date of filing : **06.11.92**

(86) International application number :
**PCT/US92/09610**

(87) International publication number :
**WO 93/11442 10.06.93 Gazette 93/14**

(54) METHOD FOR OPTIMIZING ERROR CORRECTIONS FOR BINARY LOGIC COMPONENTS.

(30) Priority : **25.11.91 US 797526**

(43) Date of publication of application :
**14.09.94 Bulletin 94/37**

(45) Publication of the grant of the patent :
**02.11.95 Bulletin 95/44**

(84) Designated Contracting States :
**DE FR GB**

(56) References cited :
**US-A- 4 717 894
IEEE TRANSACTIONS ON INSTRUMEN-
TATION AND MEASUREMENT vol. IM-36, no.
4, December 1987, NEW YORK US pages 918 -
922 R. S. TURGEL, D. F. VECCHIA 'Precision
Calibration of Phasae Meters'**

(73) Proprietor : **AlliedSignal Inc.
101 Columbia Road,
P.O. Box 2245
Morristown, New Jersey 07962-2245 (US)**

(72) Inventor : **KOMAREK, Stefan, R.
10272 Rosewood
Overland Park, KS 66207 (US)**

(74) Representative : **Brock, Peter William et al
Urquhart-Dykes & Lord
1 Richfield Place
Richfield Avenue
Reading RG1 8EQ Berkshire (GB)**

EP 0 614 533 B1

## Description

Background on the Invention

Field of the Invention:

The present invention relations to a method for optimizing error corrections, more specifically it relations to optimizing error corrections for binary logic components.

Description of the Related Art:

A binary logic component is a component that has two states. The first state is an active state in which the component performs a desired function. The second state is an inactive state in which the component does not perform the desired function. The desired function can be digital or analog in nature. It can involve filtering such as low pass filtering, band pass filtering or high pass filtering and may include adjustable cutoff frequencies and band widths. The function can also be a phase shift function where the amount of the electrical phase may be adjustable. The component can also perform an attenuation or amplification function where the amount of attenuation or the amount of amplification may be adjustable. Other types of signal processing functions are also possible.

In some applications, binary logic components interact in a fashion that makes it difficult to adjust a component to minimize the overall error produced by several binary logic components acting together. An example of such a situation relates to binary logic components used in microwave applications. In this situation, factors such as impedance mismatches make it difficult to adjust the binary logic components in a fashion that minimizes the overall error produced by a group of binary logic components acting together. The adjustment is difficult because the way in which the binary logic components interact is a function of what combination of components are in their active states.

In the past, this problem was approached using a trial and error method. The procedure involved minimizing the error by making an initial adjustment to each binary logic component while the other binary logic components were in an inactive state. Unfortunately, when the other components where activated, the resulting error for the group of components acting together was not minimized. In addition, the resulting error varied depending on which of the other binary logic components were active. This problem was addressed by a trial and error method of individually readjusting each of the binary logic components in a effort to minimize the overall error produced by the group of components acting together. This procedure was time consuming and inefficient.

US-A-4717894 discloses such a process for the calibration of a standard vector modulator circuit modified by adding phase shifters to adjust teh relative phases of the I and Q components of the RF carrier. Variable attenuators are inserted in the I and Q modulation signal input lines to adjust the relative amplitude of the modulation signals.

Calibration measurements are made using a scalar detector to measure the amplitude of the RF output signal. Two DC signal sources provide reference signals for the I and Q modulation inputs. Two other DC signal sources provide carrier leak compensation signals. A final DC signal source provides calibration signals for balancing the amplitude of the I and Q modulation signals.

An iterative four step calibration process is followed until no change in the results is observed. The quadrature phase error is minimized by adjusting the phase shifters. The carrier leakage is minimized by adjusting the carrier leak compensation sources to minimize RF output with the modulation inputs grounded. The amplitudes of the I and Q modulation signals are balanced by adjusting the attenuators until the output amplitudes are equal. Finally, the quadrature calibration signal sources are adjusted until the output amplitudes they produce are balanced.

Turgel + Vecchia in IEEE Transactions on Instrumentation and Measurement, Vol. 1-M-36, No. 4, Dec 1987, pages 918-922 discuss a substantial approach to calibration of a phase meter with a nominally linear response as an example. This approach is discussed for producing worst-case offsets of the meter response characteristic from the value of the reference standard. A linear calibration curve is used to model the meter response, and statistical test the appropriateness of the model and whether the calculated calibration curve differs significantly from the ideal. Various levels of correction to be applied can then be determined on the basis of these tests, and limits to offsets are calculated for each of the levels. By extending this approach, it is possible to predict limits of uncertainty when using the calibrated meter to make measurements.

The present invention relates to a method for optimizing error corrections for a plurality of binary logic components. The method involves adjusting each binary logic component to minimize a difference between an actual performance and a desired performance while the other binary logic components are in an inactive state. After this initial adjustment, a plurality of performance errors are determined by calculating a difference between a desired performance and an actual performance for a plurality of combinations of states of the plurality of binary logic components. An error difference associated with a binary logic component is determined by comparing a first performance error and a second performance error. The first performance error corresponds to a first combination of states of the plurality of binary logic components, and the second performance error corresponds to a second combination of states of the plurality of binary logic components. The first and second combination of states differ only by a state of the binary logic component. The error difference associated with the binary logic component is then used to readjust the binary logic component.

The present invention uses statistical methods based on Tables of Contrasts and Yates' Algorithm to determine full-factorial main effects. A full-factorial analysis is a statistical analysis in which the responses of all possible binary logic states are compared. The full-factorial analysis is used to quantify the main effects which are the error contributions of each of the individual binary logic components. These main effects are then used as adjustment values for each binary logic component, so that an overall improvement in performance is achieved without involving time consuming and inefficient methods such as trial and error.

Brief Description of the Drawings

Figure 1 illustrates a group of binary logic components comprising a six bit phase shifter;
Figure 2 illustrates phase error as a function of a hexadecimal control value;
Figure 3 is an example of a three-variable table of contrasts;
Figure 4 illustrates the resulting phase error as a function of a hexadecimal control value after optimizing the error correction values for the phase shifters;
Figures 5A, 5B, 5C and 5D comprise a table illustrating the use of Yates' algorithm; and
Figure 6 is a block diagram illustrating an automated set up for obtaining the error correction values for the phase shifters.

Description of the Preferred Embodiments

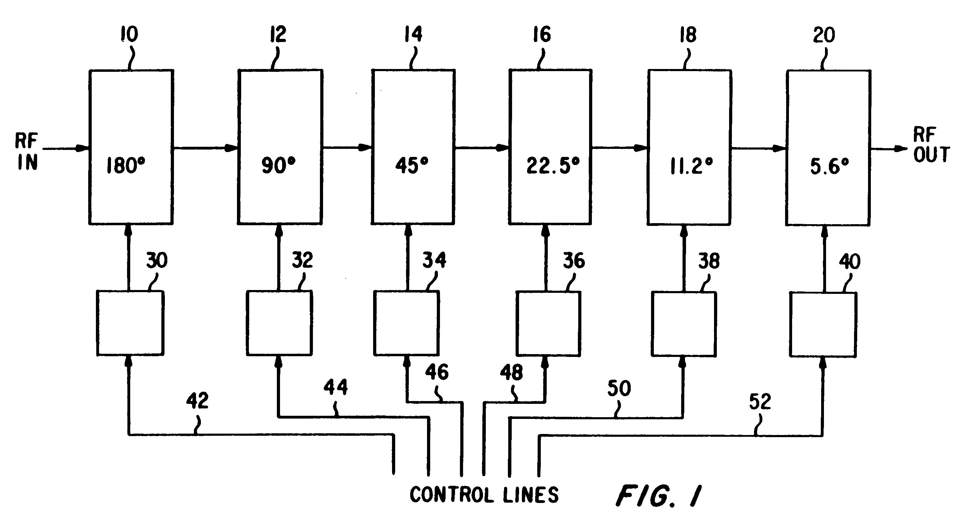

Figure 1 illustrates a six bit variable phase shifter block diagram comprising six phase shifters that are binary logic components. Each phase shifter is controlled by a driver which places the phase shifter in either an active or inactive state. When in an active state, the phase shifter produces a desired phase shift, and when in an inactive state, the phase shifter produces no phase shift and passes a signal from its input to output. The RF input to the six bit variable phase shifter is received by phase shifter 10 which introduces a 180 degree phase shift when it is active and no phase shift when inactive. The output from phase shifter 10 is received by phase shifter 12 which introduces a 90 degree phase shift when active and no phase shift when inactive. The output of phase shifter 12 is received by phase shifter 14 which introduces a 45 degree phase shift when active and no phase shift when inactive. Phase shifter 16 receives the output from phase shifter 14 and introduces a 22.5 degree phase shift when activate and no phase shift when inactive. Phase shifter 18 receives the output from phase shifter 16 and introduces a 11.2 degree phase shift when active and no phase shift when inactive, and phase shifter 20 receives the output from phase shifter 18 and introduces a 5.6 degree phase shift when active and no phase shift when inactive.

Phase shifters 10, 12, 14, 16, 18 and 20 are controlled by drivers 30, 32, 34, 36, 38 and 40 respectively. Drivers 30, 32, 34, 36, 38 and 40 are controlled using control lines 42, 44, 46, 48, 50 and 52 respectively. When a driver receives a logic 1 on its control line, it places its associated phase shifter in an active state, and when the driver receives a logic 0 on its control line, it places its associated phase shifter in an inactive state. For example, if all the control lines receive a value of logic 0, the RF input into the six bit variable phase shifter will be passed to the output of the six bit phase shifter without receiving a phase shift. If control line 48 is set equal to logic 1 and the remaining control lines are set equal to logic 0, the six bit phase shifter will provide a total phase shift of 22.5 degrees. Table 1 illustrates the differing amounts of phase shift that can be obtained for the different combinations of logic 0 and logic 1 supplied to the control lines. Table 1 also assigns a hexadecimal value to each of the combinations.

## TABLE 1

| Hex Value | Control Lines | | | | | | Desired Phase Shift in degrees |
|---|---|---|---|---|---|---|---|
| | 42 | 44 | 46 | 48 | 50 | 52 | |
| 0 | 0 | 0 | 0 | 0 | 0 | 0 | 0 |
| 1 | 0 | 0 | 0 | 0 | 0 | 1 | 5.6 |
| 2 | 0 | 0 | 0 | 0 | 1 | 0 | 11.2 |
| 3 | 0 | 0 | 0 | 0 | 1 | 1 | 16.8 |
| 4 | 0 | 0 | 0 | 1 | 0 | 0 | 22.5 |
| 5 | 0 | 0 | 0 | 1 | 0 | 1 | 28.1 |
| 6 | 0 | 0 | 0 | 1 | 1 | 0 | 33.7 |
| 7 | 0 | 0 | 0 | 1 | 1 | 1 | 39.3 |
| 8 | 0 | 0 | 1 | 0 | 0 | 0 | 45 |
| 9 | 0 | 0 | 1 | 0 | 0 | 1 | 50.6 |
| A | 0 | 0 | 1 | 0 | 1 | 0 | 56.2 |
| B | 0 | 0 | 1 | 0 | 1 | 1 | 61.8 |
| C | 0 | 0 | 1 | 1 | 0 | 0 | 67.5 |
| D | 0 | 0 | 1 | 1 | 0 | 1 | 73.1 |
| E | 0 | 0 | 1 | 1 | 1 | 0 | 78.7 |
| F | 0 | 0 | 1 | 1 | 1 | 1 | 84.3 |
| 10 | 0 | 1 | 0 | 0 | 0 | 0 | 90 |
| 11 | 0 | 1 | 0 | 0 | 0 | 1 | 95.6 |
| 12 | 0 | 1 | 0 | 0 | 1 | 0 | 101.2 |
| 13 | 0 | 1 | 0 | 0 | 1 | 1 | 106.8 |
| 14 | 0 | 1 | 0 | 1 | 0 | 0 | 112.5 |
| 15 | 0 | 1 | 0 | 1 | 0 | 1 | 118.1 |
| 16 | 0 | 1 | 0 | 1 | 1 | 0 | 123.7 |
| 17 | 0 | 1 | 0 | 1 | 1 | 1 | 129.3 |
| 18 | 0 | 1 | 1 | 0 | 0 | 0 | 135 |
| 19 | 0 | 1 | 1 | 0 | 0 | 1 | 140.6 |
| 1A | 0 | 1 | 1 | 0 | 1 | 0 | 146.2 |
| 1B | 0 | 1 | 1 | 0 | 1 | 1 | 151.8 |
| 1C | 0 | 1 | 1 | 1 | 0 | 0 | 157.5 |
| 1D | 0 | 1 | 1 | 1 | 0 | 1 | 163.1 |
| 1E | 0 | 1 | 1 | 1 | 1 | 0 | 168.7 |
| 1F | 0 | 1 | 1 | 1 | 1 | 1 | 174.3 |
| 20 | 1 | 0 | 0 | 0 | 0 | 0 | 180 |
| 21 | 1 | 0 | 0 | 0 | 0 | 1 | 185.6 |
| 22 | 1 | 0 | 0 | 0 | 1 | 0 | 191.2 |
| 23 | 1 | 0 | 0 | 0 | 1 | 1 | 196.8 |
| 24 | 1 | 0 | 0 | 1 | 0 | 0 | 202.5 |
| 25 | 1 | 0 | 0 | 1 | 0 | 1 | 208.1 |
| 26 | 1 | 0 | 0 | 1 | 1 | 0 | 213.7 |
| 27 | 1 | 0 | 0 | 1 | 1 | 1 | 219.3 |
| 28 | 1 | 0 | 1 | 0 | 0 | 0 | 225 |
| 29 | 1 | 0 | 1 | 0 | 0 | 1 | 230.6 |
| 2A | 1 | 0 | 1 | 0 | 1 | 0 | 236.2 |

TABLE 1 cont.

| Hex Value | Control Lines | | | | | | Desired Phase Shift in degrees |
|---|---|---|---|---|---|---|---|
| | 42 | 44 | 46 | 48 | 50 | 52 | |
| 2B | 1 | 0 | 1 | 0 | 1 | 1 | 241.8 |
| 2C | 1 | 0 | 1 | 1 | 0 | 0 | 247.5 |
| 2D | 1 | 0 | 1 | 1 | 0 | 1 | 253.1 |
| 2E | 1 | 0 | 1 | 1 | 1 | 0 | 258.7 |
| 2F | 1 | 0 | 1 | 1 | 1 | 1 | 264.3 |
| 30 | 1 | 1 | 0 | 0 | 0 | 0 | 270 |
| 31 | 1 | 1 | 0 | 0 | 0 | 1 | 275.6 |
| 32 | 1 | 1 | 0 | 0 | 1 | 0 | 281.2 |
| 33 | 1 | 1 | 0 | 0 | 1 | 1 | 286.8 |
| 34 | 1 | 1 | 0 | 1 | 0 | 0 | 292.5 |
| 35 | 1 | 1 | 0 | 1 | 0 | 1 | 298.1 |
| 36 | 1 | 1 | 0 | 1 | 1 | 0 | 303.7 |
| 37 | 1 | 1 | 0 | 1 | 1 | 1 | 309.3 |
| 38 | 1 | 1 | 1 | 0 | 0 | 0 | 315 |
| 39 | 1 | 1 | 1 | 0 | 0 | 1 | 320.6 |
| 3A | 1 | 1 | 1 | 0 | 1 | 0 | 326.2 |
| 3B | 1 | 1 | 1 | 0 | 1 | 1 | 331.8 |
| 3C | 1 | 1 | 1 | 1 | 0 | 0 | 337.5 |
| 3D | 1 | 1 | 1 | 1 | 0 | 1 | 343.1 |
| 3E | 1 | 1 | 1 | 1 | 1 | 0 | 348.7 |
| 3F | 1 | 1 | 1 | 1 | 1 | 1 | 354.3 |

The first step in optimizing the error corrections for each of the phase shifters involves adjusting each phase shifter for its desired phase shift while the other phase shifters are inactive. For example, phase shifter 20 is adjusted to produce a 5.6 degree phase shift while the control lines receive a hexadecimal value of 1. A hexadecimal value of 1 places phase shifters 10, 12, 14, 16 and 18 in an inactive state and places phase shifter 20 in an active state. Phase shifter 18 is then adjusted to produce an 11.2 degree phase shift while the control lines receive a hexadecimal value of 2. A value of 2 places phase shifters 10, 12, 14, 16 and 20 in an inactive state while phase shifter 18 remains in an active state. The remaining phase shifters are adjusted in a similar fashion to produce a desired phase shift.

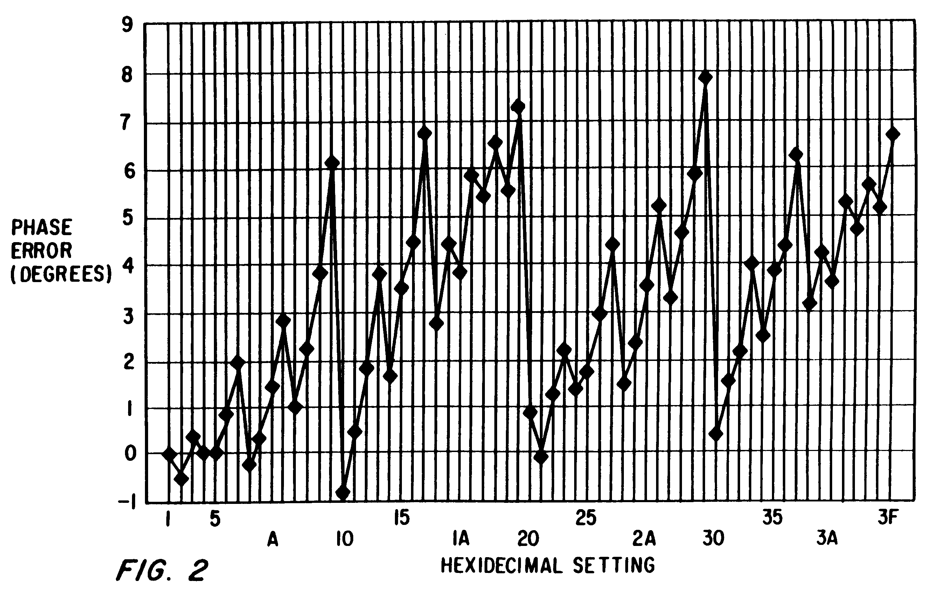

Unfortunately, when more than one phase shifter is placed in an active state, the phase shifters produce an error which results from factors such as impedance mismatching. Figure 2 illustrates an example of a phase error that results from different combinations of active phase shifters as shown by the hexadecimal settings on the horizontal axis. The errors are relatively small for hexadecimal values corresponding to only one phase shifter being active, however, the errors are relatively large for hexadecimal values corresponding to several phase shifters being in an active state simultaneously.

The performance of the six bit phase shifter is improved by adjusting each phase shifter so that the overall error produced by the plurality of phase shifters is decreased. The optimum error correction values for each of the phase shifters is obtained by calculating the main error effects of each binary phase shifter. These main error effects are determined by performing a statistical full-factorial analysis on averaged readings of phase errors.

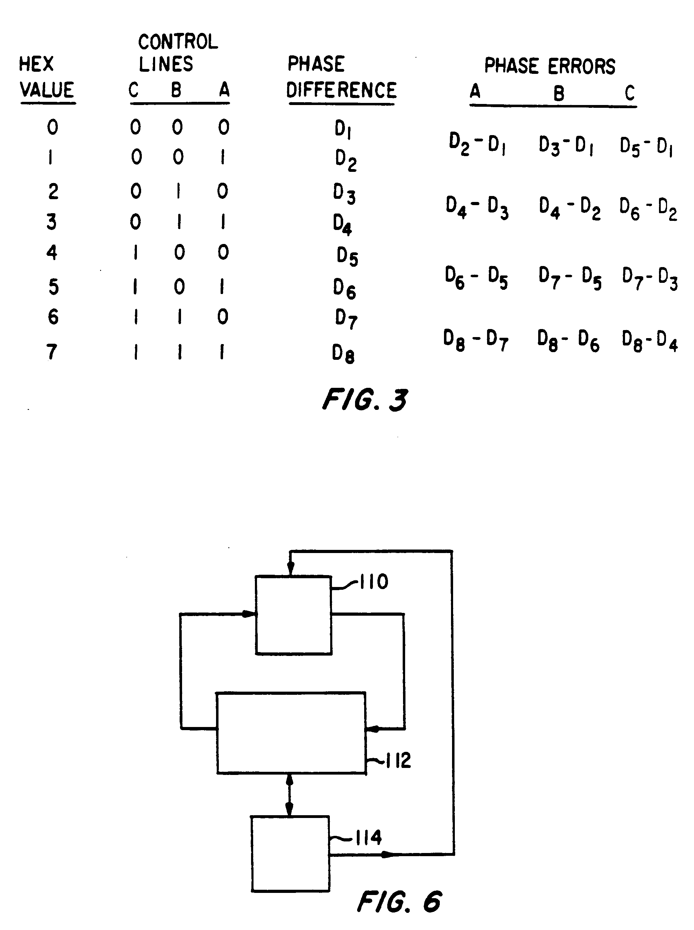

Figure 3 is a table illustrating the above referenced technique for a three bit variable phase shifter. The column of binary numbers corresponds to the control lines for phase shifters A, B and C. Whenever a bit has a value of 1, the corresponding phase shifter is placed in an active state, and whenever a bit has a value of 0, the corresponding phase shifter is placed in an inactive state. The phase error or performance error column corresponds to the difference between a desired and measured phase shift produced by the three bit phase shifter for each of the possible combinations of phase shifter states.

The phase error differences associated with phase shifter A are obtained by substracting the phase errors for several pairs of measurements. The pairs of measurements are chosen so that only the state of phase shifter A changes while the state of the other phase shifters remain unchanged. The resulting phase error differences are then averaged to obtain an average phase error difference or a main error effect associated with phase shifter A. Phase shifter A is then readjusted, while the other phase shifters are inactive, to compensate for the main error effect.

The main error effect for phase shifter B is obtained in a similar way. As with phase shifter A, the phase error differences are calculated by subtracting the phase errors for several pairs of measurements. The pairs are chosen so that the state of phase shifter B changes while the states of the other phase shifters remain constant. The phase error differences associated with phase shifter B are obtained by taking the differences D3-D1, D4-D2, D7-D5 and D8-D6. The phase error differences are then summed and divided by 4 to obtain a main error effect which is compensated for by readjusting phase shifter B while the other phase shifters are inactive.

Phase shifter C is treated in a similar fashion. The subtractions carried out in this situation are D5-D1, D6-D2, D7-D3 and D8-D4. These error differences are then summed and divided by 4 to produce a main error effect. Phase shifter C is then readjusted, while the other phase shifters are inactive, to compensate for this main error effect.

The following equations summarize the above described calculations.

$$A \text{ MAIN ERROR EFFECT } =$$
$$[(D2 - D1) + (D4 - D3) + (D6 - D5) + (D8 - D7)]/4$$
$$B \text{ MAIN ERROR EFFECT } =$$
$$[(D3 - D1) + (D4 - D2) + (D7 - D5) + (D8 - D6)]/4$$
$$C \text{ MAIN ERROR EFFECT } =$$
$$[(D5 - D1) + (D6 - D2) + (D7 - D3) + (D8 - D4)]/4$$

By readjusting each of the phase shifters as described above, the overall error for a three bit phase shifter is reduced. The overall error for a six bit phase shifter can be minimized in a similar fashion.

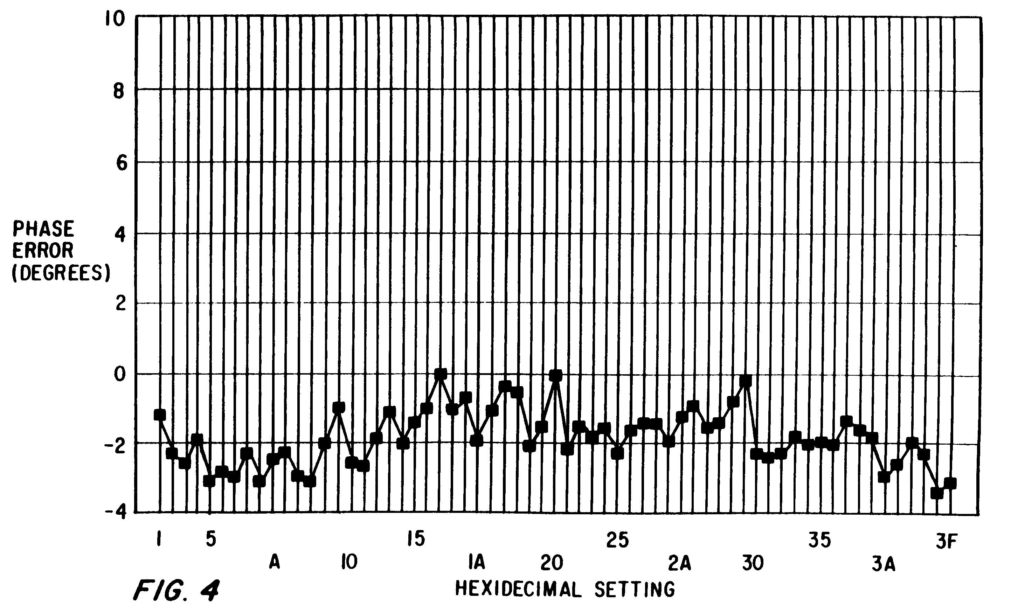

Figure 4 illustrates an example of a phase shift error for the six bit phase shifter of figure 1 after each phase shifter has been readjusted using the method described with the respect to the three bit phase shifter. The figure illustrates that the phase error does not exceed approximately 3.5 degrees. This is an improvement over the situation illustrated in figure 2 where the maximum error was nearly 8 degrees.

The present invention makes use of Yates' algorithm to categorize and quantify the sources of errors in a system comprising binary logic components. The error sources comprise main error effects and interactive error effects. Main error effects are errors caused by individual binary logic components, and interactive error effects are errors caused by the combined effects of two or more binary logic components. The main error effects can be corrected by adjusting a particular binary logic component.

Information on Yates' algorithm can be obtained from numerous texts, including STATISTICS FOR EXPERIMENTERS by G.E.P. Box, W. Hunter and J.S. Hunter (John Wiley & Sons, 1978) pages 322-325 and 342-345 or in teh original publication by F. Yates entitled THE DESIGN AND ANALYSIS OF FACTORIAL EXPERIMENTS, Bulletin 35, Imperial Bureau of Soil Science, Harpneden, Herts, England, Hafner (Macmillan).

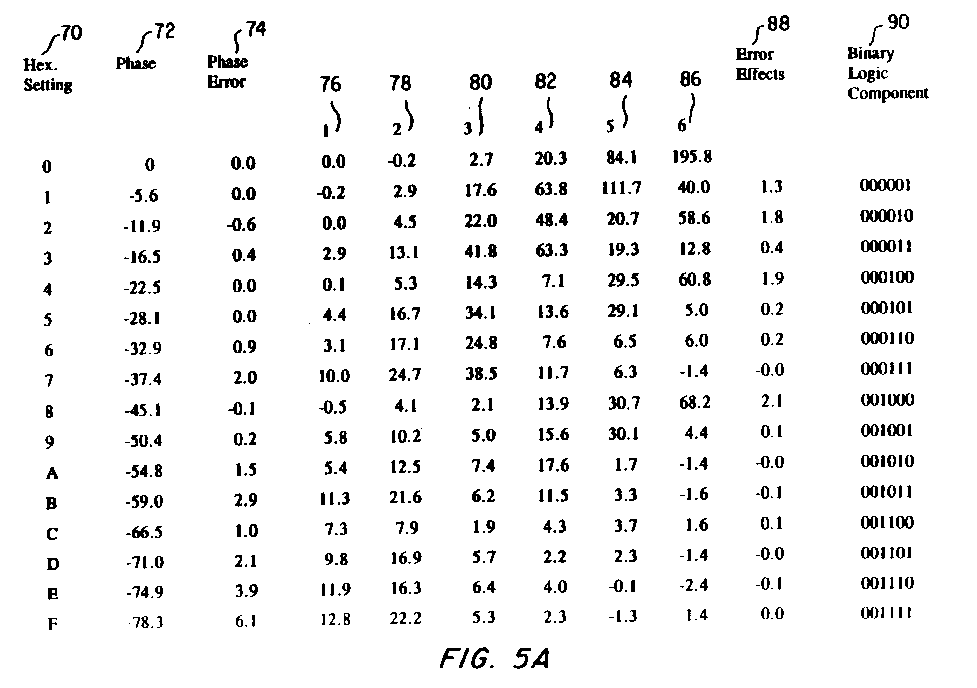

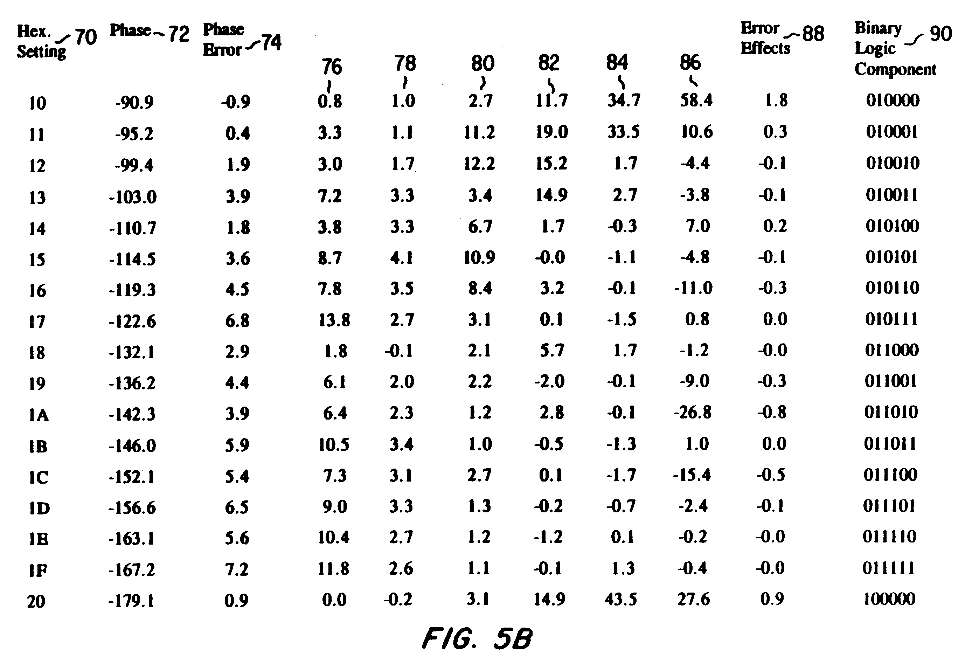

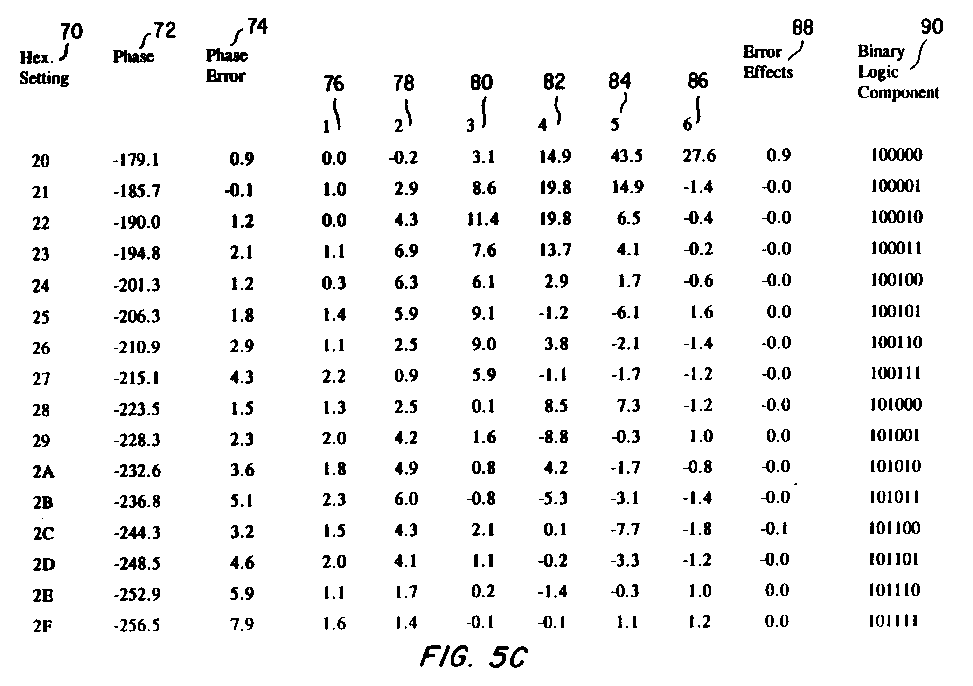

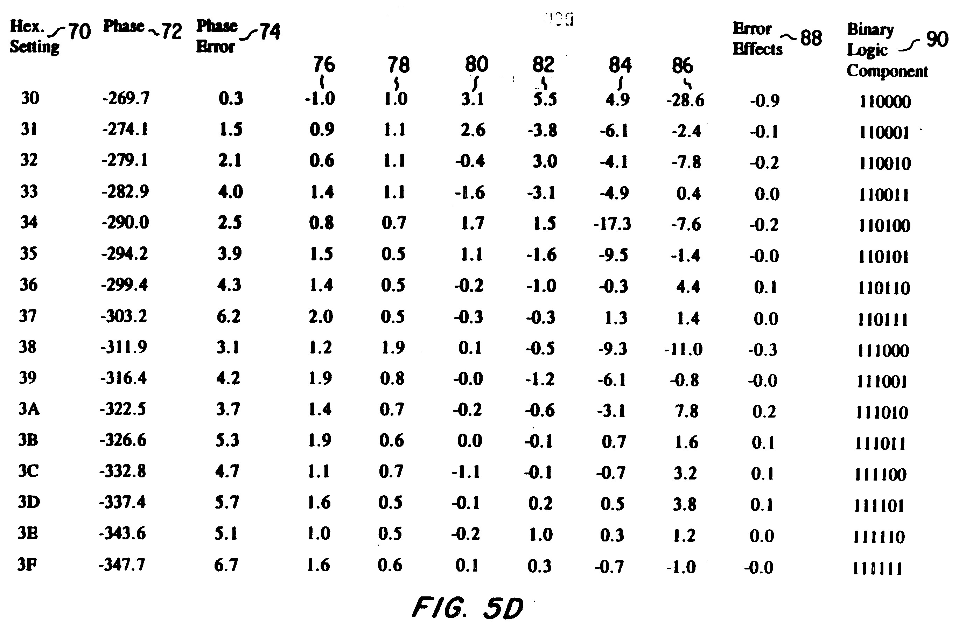

Figures 5A, 5B, 5C and 5D comprise a table that illustrates an example of using Yates' algorithm to categorize and quantify the above referenced error contributions. In this illustration the table refers to the six bit phase shifter shown in figure 1. Column 70 lists the hexadecimal settings corresponding to the control line values of the drivers in figure 1. Column 72 refers to the measured performance or the phase measured at the output of the six bit phase shifter for each hexadecimal setting. Before these measurements are taken, each of the phase shifters is adjusted to produce minimal error while the remaining phase shifters are inactive. Column 74 refers to the performance error or phase error measured for each of the hexadecimal settings; the phase error is equal to the difference between the actual phase measurement of column 72 and the desired phase shift. For each hexadecimal setting, it is preferable to calculate a plurality of phase errors, and then average them before entering them into column 74. The noise related portion of the phase error is filtered out by taking the average. Next to column 74 are variable columns 76, 78, 80, 82, 84 and 86. One variable column is provided for each variable or binary logic component comprising the system being analyzed. In this illustration, six variable columns are provided for the six phase shifters.

The values in column 76 are obtained using the sums and differences of the values contained in column 74. For the sake of convenience, the values in each column will be referenced with respect to the hexadecimal values in the corresponding row of column 70. The value in row 0 of column 76 is obtained by adding the values in row 0 and row 1 of column 74. The value in row 1 of column 76 is obtained by adding the values in row 2 and row 3 of column 74. The value in row 3 of column 76 is obtained by adding the values in row 4 and row 5 of column 74. This type of operation is continued until the value in row 1F of column 76 is obtained by adding the values in row 3E and row 3F of column 74. The remaining values of column 76 are obtained by taking the difference between values contained in column 74. The value in row 20 of column 76 is obtaining by subtracting the value in row 0 of column 74 from the value in row 1 of column 74. The value in row 21 of column 76 is obtained by subtracting the value in row 2 of column 74 from the value in row 3 of column 74. The value in row 22 of column 76 is obtained by subtracting the value in row 4 of column 74 from the value in row 5 of column 74. The value in row 23 of column 76 is obtained by subtracting the value in row 6 of colunm 74 from the value in row 7 of column 74. This type of operation continues until column 76 is completed by obtaining the value in row 3F of column 76 by subtracting the value in row 3E of column 74 from the value in row 3F of column 74.

Columns 78, 80, 82, 84, and 86 are completed in a similar fashion. Column 78 is completed by taking the sums and differences of the values in column 76 in the same fashion as column 76 was completed by taking the sums and differences of the values in column 74. Column 80 is completed by taking the sums and differences of the values in column 78 in the same fashion as column 76 was completed by taking the sums and differences of the values in column 74. Column 82 is completed by taking the sums and differences of the values in column 80 in the same fashion as column 76 was completed by taking the sums and differences of the values in column 74. Column 84 is completed by taking the sums and differences of the values in column 82 in the same fashion as column 76 was completed by taking the sums and differences of the values in column 74. Column 86 is completed by taking the sums and differences of the values in column 84 in the same fashion as column 76 was completed by taking the sums and differences of the values in column 74.

Column 88 quantifies each of the error effects. Column 88 is completed by dividing the value in column 86 by 32. In situations that use more or less than six binary logic components, there will be more or less than six columns between columns 74 and 88. In those cases, the value in column 88 is calculated by dividing the value in the column immediately preceding column 88 by $2^{n-1}$, where n is the number of binary logic components in the system. Values are provided for column 88 beginning with row 1 and continuing through row 3F. The value in row 1 of column 88 is obtained by dividing the value in row 1 of column 86 by 32. The value in row 2 of column 88 is obtained by dividing the value in row 2 of column 86 by 32. This type of operation continues until column 88 is completed by obtaining the value in row 3F of column 88 by dividing the value in row 3F of column 86 by 32.

Column 90 categorizes each error effect identified in column 88. The binary numbers in column 90 indicate the source of the errors. Each digit of a binary number corresponds to a binary logic component. The right most digit corresponds to the binary logic component that is controlled by the least significant bit of the hexadecimal settings of column 70. The second digit from the right in a binary number corresponds to the binary logic component that is controlled by the second least significant bit of the hexadecimal settings. The third digit from the right in the binary number corresponds to the binary logic component that is controlled by the third least significant bit of the hexadecimal settings. The fourth digit from the right in the binary number corresponds to the binary logic component that is controlled by the fourth least significant bit of the hexadecimal settings. The fifth digit from the right in the binary number corresponds to the binary logic component that is controlled by the fifth least significant bit of the hexadecimal settings. The sixth digit from the right in the binary number corresponds to the binary logic component that is controlled by the sixth least significant bit of the hexadecimal settings. When only one digit in the binary number contains a "1", it indicates that the error effect in the corresponding row of column 88 is associated with the binary logic component or phase shifter corresponding to the digit. When multiple digits in the binary numbers in column 90 contain a "1", it indicates that the corresponding error effect in column 88 results from interactive error effects of the binary logic components or phase shifters corresponding to the digits in the binary number containing a "1".

The values in column 88 that are associated with a single binary logic component or phase shifter result from main error effects, and are the values that are used by the present invention to minimize the overall error produced by the six bit phase shifter of figure 1. The binary numbers in column 90 indicate that rows 1, 2, 4, 8, 10 and 20 are the rows corresponding to a single binary logic component. The value in row 1 of column 88 corresponds to phase shifter 20 and is compensated for by readjusting phase shifter 20 when the control lines are equal to hexadecimal 1. The value in row 2 of column 88 corresponds to phase shifter 18 and is compensated for by readjusting phase shifter 18 when the control lines are equal to hexadecimal 2. The value in row 4 of column 88 corresponds to phase shifter 16 and is compensated for by readjusting phase shifter 16 when the control lines are equal to hexadecimal 4. The value in row 8 of column 88 corresponds to phase shifter 14 and is compensated for by readjusting phase shifter 14 when the control lines are equal to hexadecimal 8. The value in row 10 of column 88 corresponds to phase shifter 12 and is compensated for by readjusting phase shifter 12 when the control lines are equal to hexadecimal 10. The value in row 20 of column 88 corresponds to phase shifter 10 and is compensated for by readjusting phase shifter 10 when the control lines are equal to hexadecimal 20.

The phase shifters are readjusted to compensate for the corresponding value in column 88 by adjusting their phase shift so that it is equal to the original phase shift plus the value in column 88. For example, phase shifter 20 is normally adjusted to 5.6 degrees. Row 1 of column 88 contains a value of 1.3 degrees. In order to compensate for the 1.3 degrees, phase shifter 20 is readjusted to provide a shift of 6.9 degrees rather than 5.6 degrees. The other phase shifters are adjusted in similar fashion.

By using the above described method, optimized error correction value can be obtained for a group of binary logic components. This method applies to a group containing any number of binary logic components and to binary logic components performing any function. Some typical applications that use binary logic components are phase shifters, attenuators, amplifiers, filters, and any other type of application in which binary logic components are used.

Figure 8 illustrates an automated set up for gathering the data necessary to obtain the optimized error correction values. Unit under test 110 is the device containing the binary logic components. In this example, unit 110 is the six bit variable phase shifter of figure 1. Vector network analyzer 112 provides an input to unit 110 and receives the output from unit 110. It is preferable to use a Hewlett Packard 8753C vector network analyzer. The network analyzer provides the input to unit 110 and compares the input with the output received from unit 110 to determine the resulting phase shift. Computer 114 is used to control network analyzer 112. Computer 114 also controls the states of the individual phase shifters by providing a hexadecimal values to unit 110. Computer 114 can be any type computer that is convenient for controlling network analyzer 112 and controlling the switching of the binary logic components within unit 110, however, it is preferable to use a desk top computer.

Computer 114 selects which of the phase shifters will be placed in a active state by transferring the appropriate hexadecimal value to unit 110. Computer 114 then obtains data regarding the phase shift produced by unit 110 using analyzer 112. When unit 112 measures the phase shift, it is preferable that unit 112 average a plurality of measurements to remove phase jitter that results from noise. Computer 114 continues this process for all possible phase shifter states. Computer 114 uses this information to complete an above described table and thereby produces the optimized error correction values for each phase shifter or binary logic component. Computer 114 can be programmed using any convenient programming language to facilitate producing an above described table.

## Claims

1. A method for optimizing error corrections for a plurality of binary logic components wherein each binary logic component comprises an active state and an inactive state, the method comprising the steps of:

   (a) adjusting each binary logic component to minimize a difference between an actual performance in said active state and a desired performance while another binary logic component is in said inactive state;

   (b) determining a plurality of performance errors by calculating a difference between a desired performance and an actual performance in said active state for a plurality of combinations of states of said plurality of binary logic components (74);

   (c) determining an error difference associated with a binary logic component by comparing a first and a second performance error, said first performance error corresponding to a first combination of active and inactive states of said plurality of binary logic components and said second performance error corresponding to a second combination of active and inactive states of said plurality of binary logic components, said first and said second combination of active and inactive states differing only by a state of said binary logic component (76); and

   (d) adjusting said binary logic component based on said error difference associated with said binary logic component.

2. The method of claim 1, wherein the step of adjusting each binary logic component to minimize a difference between an actual performance and a desired performance is performed while a plurality of other binary logic components are in said inactive states.

3. The method of claim 1, wherein the step of determining an error difference associated with a binary logic component comprises determining a plurality of error differences associated with said binary logic component.

4. The method of claim 3, further comprising the step of averaging said plurality of error differences.

5. The method of claim 1, wherein the step of determining an error difference associated with a binary logic component comprises determining an error difference associated with each of said plurality of binary logic components (78-86).

6. The method of claim 5, further comprising the step of adjusting each of said plurality of binary logic components based on said error difference associated with each of said plurality of binary logic components (88).

7. The method of claim 6, wherein the step of determining an error difference associated with a binary logic component comprises determining a plurality of error differences associated with each of said plurality of binary logic components.

8. The method of claim 7, further comprising the step of averaging said plurality of error differences associated with each of said plurality of binary logic components.

9. The method of claim 1, wherein the step of adjusting each binary logic component to minimize a difference between an actual performance and a desired performance comprises adjusting a phase shift produced by said binary logic component.

10. A method for optimizing error corrections for a plurality of binary logic components, wherein each binary logic component comprises an active state and an inactive state, the method comprising the steps of:
    (a) adjusting a phase shift introduced by each binary logic component to minimize a difference between an actual performance and a desired performance while a plurality of other binary logic components are in said inactive states;
    (b) determining a plurality of phase errors by calculating a difference between a desired phase shift and an actual phase shift for a plurality of combinations of states of said plurality of binary logic components (74);
    (c) determining a plurality of phase error differences associated with each of said plurality of binary logic components, a phase error difference associated with a binary logic component being determined by comparing a first and a second phase error, said first phase error corresponding to a first combination of active and inactive states of said plurality of binary logic components and said second phase error corresponding to a second combination of active and inactive states of said plurality of binary logic components, said first and said second combination of states active and inactive differing only by a state of said associated binary logic component (76-86);
    (d) averaging said plurality of phase error differences associated with each of said plurality of binary logic components; and
    (e) adjusting each of said plurality of binary logic components based on an average phase error difference associated with each of said plurality of binary logic components (88).

**Patentansprüche**

1. Verfahren zur Optimierung der Fehlerkorrekturen für eine Mehrzahl von binären logischen Komponenten, bei dem jede binäre logische Komponente einen aktiven Zustand und einen inaktiven Zustand aufweist und das Vefahren die folgenden Schritte umfaßt:
    (a) Einstellen jeder binären logischen Komponente, um eine Differenz zwischen einer Ist-Leistung im aktiven Zustand und einer gewünschten Leistung, während sich eine andere binäre logische Komponente im inaktiven Zustand befindet, auf ein Minimum zu bringen;
    (b) Feststellen einer Mehrzahl von Leistungsfehlern durch Berechnen einer Differenz zwischen einer gewünschten Leistung und einer Ist-Leistung im aktiven Zustand für eine Mehrzahl von Zustandskombinationen der Mehrzahl binärer logischer Komponenten (74);
    (c) Feststellen einer einer binären logischen Komponente zugeordneten Fehlerdifferenz durch Vergleich eines ersten und eines zweiten Leistungsfehlers, wobei der erste Leistungsfehler einer ersten Kombination von aktiven und inaktiven Zuständen der Mehrzahl binärer logischer Komponenten entspricht und der zweite Leistungsfehler einer zweiten Kombination von aktiven und inaktiven Zuständen der Mehrzahl binärer logischer Komponenten entspricht und sich die erste und zweite Kombination aktiver und inaktiver Zustände nur durch einen Zustand der binären logischen Komponente (76) unterscheidet; und
    (d) Einstellen der binären logischen Komponente auf der Basis der der binären logischen Komponente zugeordneten Fehlerdifferenz.

2. Verfahren nach Anspruch 1, bei dem der Schritt des Einstellens jeder binären logischen Komponente, um eine Differenz zwischen einer Ist-Leistung und einer gewünschten Leistung auf ein Minimum zu bringen, ausgeführt wird, während eine Mehrzahl anderer binärer logischer Komponenten sich in inaktiven Zuständen befinden.

3. Verfahren nach Anspruch 1, bei dem der Schritt des Feststellens einer einer binären logischen Komponente zugeordneten Fehlerdifferenz das Feststellen einer Mehrzahl von der binären logischen Komponente zugeordneten Fehlerdifferenzen umfaßt.

4. Verfahren nach Anspruch 3, welches ferner den Schritt der Durchschnittsbildung aus der Mehrzahl von Fehlerdifferenzen umfaßt.

5. Verfahren nach Anspruch 1, bei dem der Schritt des Feststellens einer einer binären logischen Komponente zugeordneten Fehlerdifferenz das Feststellen eines jeder der Mehrzahl von binären logischen Komponenten (78-86) zugeordneten Fehlerdifferenz umfaßt.

6. Verfahren nach Anspruch 5, welches ferner den Schritt des Einstellens jeder der Mehrzahl von binären logischen Komponenten auf der Basis der jeder der Mehrzahl von binären logischen Komponenten (88) zugeordneten Fehlerdifferenz.

7. Verfahren nach Anspruch 6, bei dem der Schritt des Feststellens einer einer binären logischen Komponente zugeordneten Fehlerdifferenz das Feststellen einer jeder der Mehrzahl von binären logischen Komponenten zugeordneten Mehrzahl von Fehlerdifferenzen umfaßt.

8. Verfahren nach Anspruch 7, welches ferner den Schritt der Durchschnittsbildung der jeder der Mehrzahl von binären logischen Komponenten zugeordneten Mehrzahl von Fehlerdifferenzen umfaßt.

9. Verfahren nach Anspruch 1, bei dem der Schritt des Einstellens jeder binären logischen Komponente, um eine Differenz zwischen einer Ist-Leistung und einer gewünschten Leistung auf ein Minimum zu bringen, das Einstellen einer von der binären logischen Komponente hervorgerufenen Phasenverschiebung umfaßt.

10. Verfahren zur Optimierung der Fehlerkorrekturen für eine Mehrzahl von binären logischen Komponenten, bei dem jede binäre logische Komponente einen aktiven Zustand und einen inaktiven Zustand aufweist und das Vefahren die folgenden Schritte umfaßt:

(a) Einstellen einer von jeder binären logischen Komponente eingeführten Phasenverschiebung, um eine Differenz zwischen einer Ist-Leistung und einer gewünschten Leistung, während sich eine Mehrzahl anderer binärer logischer Komponenten im inaktiven Zustand befindet, auf ein Minimum zu bringen;

(b) Feststellen einer Mehrzahl von Phasenfehlern durch Berechnen einer Differenz zwischen einer gewünschten Phasenverschiebung und einer Ist-Phasenverschiebung für eine Mehrzahl von Zustandskombinationen der Mehrzahl binärer logischer Komponenten (74);

(c) Feststellen einer Mehrzahl von jeder Mehrzahl von binären logischen Komponente zugeordneten Phasenfehlerdifferenzen, von denen eine einer binären logischen Komponente zugeordnete Phasenfehlerdifferenz durch Vergleich eines ersten und eines zweiten Phasenfehlers festgestellt wird, wobei der erste Phasenfehler einer ersten Kombination von aktiven und inaktiven Zuständen der Mehrzahl binärer logischer Komponenten entspricht und der zweite Phasenfehler einer zweiten Kombination von aktiven und inaktiven Zuständen der Mehrzahl binärer logischer Komponenten entspricht und sich die erste und zweite Kombination aktiver und inaktiver Zustände nur durch einen Zustand der zugehörigen binären logischen Komponente (76-86) unterscheidet;

(d) Durchschnittsbildung aus der Mehrzahl von jeder der Mehrzahl binärer logischer Komponenten zugeordneten Phasenfehlerdifferenzen; und

(e) Einstellen jeder der Mehrzahl von binären logischen Komponenten auf der Basis des jeder der Mehrzahl von binären logischen Komponenten (88) zugeordneten durchschnittlichen Phasenfehlerdifferenz.

EP 0 614 533 B1

**Revendications**

1. Procédé destiné à l'optimisation des corrections d'erreur pour une pluralité de composants logiques binaires dans lesquels chaque composant logique binaire comprend un état actif et un état inactif, le procédé comprenant les étapes consistant à :

   (a) régler chaque composant logique binaire de façon à minimiser une différence entre une performance réelle dans ledit état actif et une performance souhaitée pendant que les autres composants logiques binaires sont dans ledit état inactif,

   (b) déterminer une pluralité d'erreurs de performance en calculant une différence entre une performance souhaitée et une performance réelle dans ledit état actif pour une pluralité de combinaisons d'états de ladite pluralité de composants logiques binaires (74),

   (c) déterminer une différence d'erreur associée à un composant logique binaire en comparant une première et une seconde erreurs de performance, ladite première erreur de performance correspondant à une première combinaison d'états actifs et inactifs de ladite pluralité de composants logiques binaires et ladite seconde erreur de performance correspondant à une seconde combinaison d'états actifs et inactifs de ladite pluralité de composants logiques binaires, ladite première et ladite seconde combinaison d'états actifs et inactifs ne différant que par un état dudit composant logique binaire (76), et

   (d) régler chaque composant logique binaire sur la base de ladite différence d'erreur associée audit composant logique binaire.

2. Procédé selon la revendication 1, dans lequel l'étape de réglage de chaque composant logique binaire pour minimiser une différence entre une performance réelle et une performance souhaitée, est réalisée pendant qu'une pluralité d'autres composants logiques binaires sont dans lesdits états inactifs.

3. Procédé selon la revendication 1, dans lequel l'étape de détermination d'une différence d'erreur associée à un composant logique binaire comprend la détermination d'une pluralité de différences d'erreur associées audit composant logique binaire.

4. Procédé selon la revendication 3, comprenant en outre l'étape de calcul de la moyenne de ladite pluralité de différences d'erreur.

5. Procédé selon la revendication 1, dans lequel l'étape de détermination d'une différence d'erreur associée à un composant logique binaire comprend la détermination d'une différence d'erreur associée à chacun parmi ladite pluralité de composants logiques binaires (78 à 86).

6. Procédé selon la revendication 5, comprenant en outre l'étape de réglage de chacun parmi ladite pluralité de composants logiques binaires sur la base de ladite différence d'erreur associée à chacun parmi ladite pluralité de composants logiques binaires (88).

7. Procédé selon la revendication 6, dans lequel l'étape de détermination d'une différence d'erreur associée à un composant logique binaire comprend la détermination d'une pluralité de différences d'erreur associées à chacun parmi ladite pluralité de composants logiques binaires.

8. Procédé selon la revendication 7, comprenant en outre l'étape de calcul de la moyenne de ladite pluralité de différences d'erreur associées à chacun parmi ladite pluralité de composants logiques binaires.

9. Procédé selon la revendication 1, dans lequel l'étape de réglage de chaque composant logique binaire destinée à minimiser la différence entre une performance réelle et une performance souhaitée comprend le réglage d'un déphasage produit par ledit composant logique binaire.

10. Procédé destiné à l'optimisation de corrections d'erreur pour une pluralité de composants logiques binaires, dans lequel chaque composant logique binaire comprend un état actif et un état inactif, le procédé comprenant les étapes consistant à :

    (a) régler un déphasage introduit par chaque composant logique binaire de façon à minimiser une différence entre une performance réelle et une performance souhaitée alors qu'une pluralité d'autres composants logiques binaires sont dans lesdits états inactifs,

    (b) déterminer une pluralité d'erreurs de phase en calculant une différence entre un déphasage souhaité et un déphasage réel pour une pluralité de combinaisons d'états de ladite pluralité de composants

11

logiques binaires (74),

(c) déterminer une pluralité de différences d'erreur de phase associées à chacun parmi ladite pluralité de composants logiques binaires, une différence d'erreur de phase associée à un composant logique binaire étant déterminée en comparant une première et une seconde erreurs de phase, ladite première erreur de phase correspondant à une première combinaison d'états actifs et inactifs de ladite pluralité de composants logiques binaires et ladite seconde erreur de phase correspondant à une seconde combinaison d'états actifs et inactifs de ladite pluralité de composants logiques binaires, ladite première et ladite seconde combinaison d'états actifs et inactifs ne différant que par un état dudit composant logique binaire associé (76 à 86), et

(d) calculer la moyenne de ladite pluralité de différences d'erreur de phase associée à chacun parmi ladite pluralité de composants logiques binaires, et

(e) régler chacun parmi ladite pluralité de composants logiques binaires sur la base d'une différence d'erreur de phase moyenne associée à chacun parmi ladite pluralité de composants logiques binaires (88).

RF OUT

RF IN

| 20 | 18 | 16 | 14 | 12 | 10 |

5.6° | 11.2° | 22.5° | 45° | 90° | 180°

40 | 38 | 36 | 34 | 32 | 30

52 | 50 | 48 | 46 | 44 | 42

CONTROL LINES

*FIG. I*

FIG. 2

PHASE ERROR (DEGREES) vs HEXIDECIMAL SETTING

| HEX VALUE | CONTROL LINES | | | PHASE DIFFERENCE |
|:---:|:---:|:---:|:---:|:---:|
| | C | B | A | |
| 0 | 0 | 0 | 0 | $D_1$ |
| 1 | 0 | 0 | 1 | $D_2$ |
| 2 | 0 | 1 | 0 | $D_3$ |
| 3 | 0 | 1 | 1 | $D_4$ |
| 4 | 1 | 0 | 0 | $D_5$ |
| 5 | 1 | 0 | 1 | $D_6$ |
| 6 | 1 | 1 | 0 | $D_7$ |
| 7 | 1 | 1 | 1 | $D_8$ |

| PHASE ERRORS | | |
|:---:|:---:|:---:|
| A | B | C |
| $D_2 - D_1$ | $D_3 - D_1$ | $D_5 - D_1$ |
| $D_4 - D_3$ | $D_4 - D_2$ | $D_6 - D_2$ |
| $D_6 - D_5$ | $D_7 - D_5$ | $D_7 - D_3$ |
| $D_8 - D_7$ | $D_8 - D_6$ | $D_8 - D_4$ |

*FIG. 3*

*FIG. 6*

FIG. 4

PHASE ERROR (DEGREES)

HEXIDECIMAL SETTING

| Hex. Setting (70) | Phase (72) | Phase Error (74) | 76 (1) | 78 (2) | 80 (3) | 82 (4) | 84 (5) | 86 (6) | Error Effects (88) | Binary Logic Component (90) |
|---|---|---|---|---|---|---|---|---|---|---|
| 0 | 0 | 0.0 | 0.0 | -0.2 | 2.7 | 20.3 | 84.1 | 195.8 | | |
| 1 | -5.6 | 0.0 | -0.2 | 2.9 | 17.6 | 63.8 | 111.7 | 40.0 | 1.3 | 000001 |
| 2 | -11.9 | -0.6 | 0.0 | 4.5 | 22.0 | 48.4 | 20.7 | 58.6 | 1.8 | 000010 |
| 3 | -16.5 | 0.4 | 2.9 | 13.1 | 41.8 | 63.3 | 19.3 | 12.8 | 0.4 | 000011 |
| 4 | -22.5 | 0.0 | 0.1 | 5.3 | 14.3 | 7.1 | 29.5 | 60.8 | 1.9 | 000100 |
| 5 | -28.1 | 0.0 | 4.4 | 16.7 | 34.1 | 13.6 | 29.1 | 5.0 | 0.2 | 000101 |
| 6 | -32.9 | 0.9 | 3.1 | 17.1 | 24.8 | 7.6 | 6.5 | 6.0 | 0.2 | 000110 |
| 7 | -37.4 | 2.0 | 10.0 | 24.7 | 38.5 | 11.7 | 6.3 | -1.4 | -0.0 | 000111 |
| 8 | -45.1 | -0.1 | -0.5 | 4.1 | 2.1 | 13.9 | 30.7 | 68.2 | 2.1 | 001000 |
| 9 | -50.4 | 0.2 | 5.8 | 10.2 | 5.0 | 15.6 | 30.1 | 4.4 | 0.1 | 001001 |
| A | -54.8 | 1.5 | 5.4 | 12.5 | 7.4 | 17.6 | 1.7 | -1.4 | -0.0 | 001010 |
| B | -59.0 | 2.9 | 11.3 | 21.6 | 6.2 | 11.5 | 3.3 | -1.6 | -0.1 | 001011 |
| C | -66.5 | 1.0 | 7.3 | 7.9 | 1.9 | 4.3 | 3.7 | 1.6 | 0.1 | 001100 |
| D | -71.0 | 2.1 | 9.8 | 16.9 | 5.7 | 2.2 | 2.3 | -1.4 | -0.0 | 001101 |
| E | -74.9 | 3.9 | 11.9 | 16.3 | 6.4 | 4.0 | -0.1 | -2.4 | -0.1 | 001110 |
| F | -78.3 | 6.1 | 12.8 | 22.2 | 5.3 | 2.3 | -1.3 | 1.4 | 0.0 | 001111 |

FIG. 5A

EP 0 614 533 B1

| Hex. Setting /70 | Phase ~72 | Phase Error /74 | 76 | 78 | 80 | 82 | 84 | 86 | Error ~88 Effects | Binary Logic /90 Component |
|---|---|---|---|---|---|---|---|---|---|---|
| 10 | -90.9 | -0.9 | 0.8 | 1.0 | 2.7 | 11.7 | 34.7 | 58.4 | 1.8 | 010000 |
| 11 | -95.2 | 0.4 | 3.3 | 1.1 | 11.2 | 19.0 | 33.5 | 10.6 | 0.3 | 010001 |
| 12 | -99.4 | 1.9 | 3.0 | 1.7 | 12.2 | 15.2 | 1.7 | -4.4 | -0.1 | 010010 |
| 13 | -103.0 | 3.9 | 7.2 | 3.3 | 3.4 | 14.9 | 2.7 | -3.8 | -0.1 | 010011 |
| 14 | -110.7 | 1.8 | 3.8 | 3.3 | 6.7 | 1.7 | -0.3 | 7.0 | 0.2 | 010100 |
| 15 | -114.5 | 3.6 | 8.7 | 4.1 | 10.9 | -0.0 | -1.1 | -4.8 | -0.1 | 010101 |
| 16 | -119.3 | 4.5 | 7.8 | 3.5 | 8.4 | 3.2 | -0.1 | -11.0 | -0.3 | 010110 |
| 17 | -122.6 | 6.8 | 13.8 | 2.7 | 3.1 | 0.1 | -1.5 | 0.8 | 0.0 | 010111 |
| 18 | -132.1 | 2.9 | 1.8 | -0.1 | 2.1 | 5.7 | 1.7 | -1.2 | -0.0 | 011000 |
| 19 | -136.2 | 4.4 | 6.1 | 2.0 | 2.2 | -2.0 | -0.1 | -9.0 | -0.3 | 011001 |
| 1A | -142.3 | 3.9 | 6.4 | 2.3 | 1.2 | 2.8 | -0.1 | -26.8 | -0.8 | 011010 |
| 1B | -146.0 | 5.9 | 10.5 | 3.4 | 1.0 | -0.5 | -1.3 | 1.0 | 0.0 | 011011 |
| 1C | -152.1 | 5.4 | 7.3 | 3.1 | 2.7 | 0.1 | -1.7 | -15.4 | -0.5 | 011100 |
| 1D | -156.6 | 6.5 | 9.0 | 3.3 | 1.3 | -0.2 | -0.7 | -2.4 | -0.1 | 011101 |
| 1E | -163.1 | 5.6 | 10.4 | 2.7 | 1.2 | -1.2 | 0.1 | -0.2 | -0.0 | 011110 |
| 1F | -167.2 | 7.2 | 11.8 | 2.6 | 1.1 | -0.1 | 1.3 | -0.4 | -0.0 | 011111 |
| 20 | -179.1 | 0.9 | 0.0 | -0.2 | 3.1 | 14.9 | 43.5 | 27.6 | 0.9 | 100000 |

<div align="center">

*FIG. 5B*

</div>

EP 0 614 533 B1

| Hex. Setting | Phase | Phase Error | 76 1 | 78 2 | 80 3 | 82 4 | 84 5 | 86 6 | Error Effects | Binary Logic Component |
|---|---|---|---|---|---|---|---|---|---|---|
| 20 | -179.1 | 0.9 | 0.0 | -0.2 | 3.1 | 14.9 | 43.5 | 27.6 | 0.9 | 100000 |
| 21 | -185.7 | -0.1 | 1.0 | 2.9 | 8.6 | 19.8 | 14.9 | -1.4 | -0.0 | 100001 |
| 22 | -190.0 | 1.2 | 0.0 | 4.3 | 11.4 | 19.8 | 6.5 | -0.4 | -0.0 | 100010 |
| 23 | -194.8 | 2.1 | 1.1 | 6.9 | 7.6 | 13.7 | 4.1 | -0.2 | -0.0 | 100011 |
| 24 | -201.3 | 1.2 | 0.3 | 6.3 | 6.1 | 2.9 | 1.7 | -0.6 | -0.0 | 100100 |
| 25 | -206.3 | 1.8 | 1.4 | 5.9 | 9.1 | -1.2 | -6.1 | 1.6 | 0.0 | 100101 |
| 26 | -210.9 | 2.9 | 1.1 | 2.5 | 9.0 | 3.8 | -2.1 | -1.4 | -0.0 | 100110 |
| 27 | -215.1 | 4.3 | 2.2 | 0.9 | 5.9 | -1.1 | -1.7 | -1.2 | -0.0 | 100111 |
| 28 | -223.5 | 1.5 | 1.3 | 2.5 | 0.1 | 8.5 | 7.3 | -1.2 | -0.0 | 101000 |
| 29 | -228.3 | 2.3 | 2.0 | 4.2 | 1.6 | -8.8 | -0.3 | 1.0 | 0.0 | 101001 |
| 2A | -232.6 | 3.6 | 1.8 | 4.9 | 0.8 | 4.2 | -1.7 | -0.8 | -0.0 | 101010 |
| 2B | -236.8 | 5.1 | 2.3 | 6.0 | -0.8 | -5.3 | -3.1 | -1.4 | -0.0 | 101011 |
| 2C | -244.3 | 3.2 | 1.5 | 4.3 | 2.1 | 0.1 | -7.7 | -1.8 | -0.1 | 101100 |
| 2D | -248.5 | 4.6 | 2.0 | 4.1 | 1.1 | -0.2 | -3.3 | -1.2 | -0.0 | 101101 |
| 2E | -252.9 | 5.9 | 1.1 | 1.7 | 0.2 | -1.4 | -0.3 | 1.0 | 0.0 | 101110 |
| 2F | -256.5 | 7.9 | 1.6 | 1.4 | -0.1 | -0.1 | 1.1 | 1.2 | 0.0 | 101111 |

*FIG. 5C*

EP 0 614 533 B1

EP 0 614 533 B1

| Hex. Setting ⁓70 | Phase ⁓72 | Phase Error ⁓74 | 76 | 78 | 80 | 82 | 84 | 86 | Error Effects ⁓88 | Binary Logic ⁓90 Component |
|---|---|---|---|---|---|---|---|---|---|---|
| 30 | -269.7 | 0.3 | -1.0 | 1.0 | 3.1 | 5.5 | 4.9 | -28.6 | -0.9 | 110000 |
| 31 | -274.1 | 1.5 | 0.9 | 1.1 | 2.6 | -3.8 | -6.1 | -2.4 | -0.1 | 110001 |
| 32 | -279.1 | 2.1 | 0.6 | 1.1 | -0.4 | 3.0 | -4.1 | -7.8 | -0.2 | 110010 |
| 33 | -282.9 | 4.0 | 1.4 | 1.1 | -1.6 | -3.1 | -4.9 | 0.4 | 0.0 | 110011 |
| 34 | -290.0 | 2.5 | 0.8 | 0.7 | 1.7 | 1.5 | -17.3 | -7.6 | -0.2 | 110100 |
| 35 | -294.2 | 3.9 | 1.5 | 0.5 | 1.1 | -1.6 | -9.5 | -1.4 | -0.0 | 110101 |
| 36 | -299.4 | 4.3 | 1.4 | 0.5 | -0.2 | -1.0 | -0.3 | 4.4 | 0.1 | 110110 |
| 37 | -303.2 | 6.2 | 2.0 | 0.5 | -0.3 | -0.3 | 1.3 | 1.4 | 0.0 | 110111 |
| 38 | -311.9 | 3.1 | 1.2 | 1.9 | 0.1 | -0.5 | -9.3 | -11.0 | -0.3 | 111000 |
| 39 | -316.4 | 4.2 | 1.9 | 0.8 | -0.0 | -1.2 | -6.1 | -0.8 | -0.0 | 111001 |
| 3A | -322.5 | 3.7 | 1.4 | 0.7 | -0.2 | -0.6 | -3.1 | 7.8 | 0.2 | 111010 |
| 3B | -326.6 | 5.3 | 1.9 | 0.6 | 0.0 | -0.1 | 0.7 | 1.6 | 0.1 | 111011 |
| 3C | -332.8 | 4.7 | 1.1 | 0.7 | -1.1 | -0.1 | -0.7 | 3.2 | 0.1 | 111100 |
| 3D | -337.4 | 5.7 | 1.6 | 0.5 | -0.1 | 0.2 | 0.5 | 3.8 | 0.1 | 111101 |
| 3B | -343.6 | 5.1 | 1.0 | 0.5 | -0.2 | 1.0 | 0.3 | 1.2 | 0.0 | 111110 |
| 3F | -347.7 | 6.7 | 1.6 | 0.6 | 0.1 | 0.3 | -0.7 | -1.0 | -0.0 | 111111 |

FIG. 5D